# EUROPÄISCHE PATENTANMELDUNG

(11) **EP 1 245 961 A2**
(43) Veröffentlichungstag der Anmeldung: **02.10.2002**
(21) Anmeldenummer: 01112590.3
(22) Anmeldetag: 23.05.2001
(51) Int. Cl.: G01R 15/24

(54) **Stabilisierte magnetooptische Strommesseinrichtung**

(30) Priorität: 19.03.2001 EP 01106815
(71) Anmelder: SIEMENS AKTIENGESELLSCHAFT, 80333 München (DE)
(72) Erfinder: Amtmann, Karlheinz, 91466 Gerhardshofen (DE); Kull, Volker, 75059 Zaisenhausen (DE); Sperber, Jürgen, 90765 Fürth (DE)

(57) **Zusammenfassung**

Die Messeinrichtung enthält eine Sensoreinheit (2) mit einer Sensorspule (21,22,23) aus Lichtwellenleiterkabel, durch die ein stromführender elektrischer Leiter (213,223,233) geführt ist. Ein optischer Transmitter (1) mit einem Lichtquellenmodul (11) erzeugt Licht konstanter Wellenlänge für die Sensoreinheit. Ein optischer Empfänger (4) empfängt das Licht und generiert einen elektrischen Messwert (43) für die Größe des Stromes durch den elektrischen Leiter. Eine Ansteuerschaltung (30) enthält eine Temperaturregelung (33) zur Stabilisierung der Temperatur insbesondere im Lichtquellenmodul und Mittel (32) zur Erzeugung eines konstanten Speisestromes (311) für das Lichtquellenmodul. Die Temperaturregelung (33) enthält vorteilhaft einen Temperatursensor (314) und einen Temperaturregler (330) zur Erzeugung pulspausenmodulierter Stellsignale für ein steuerbares Einstellelement (315) für die Temperatur im Lichtquellenmodul, z.B. ein Peltierelement.

## Beschreibung

Die Erfindung betrifft eine magnetooptische Strommesseinrichtung. Diese ist mit einer Sensoreinheit ausgerüstet, die mindestens eine Sensorspule aus einem Lichtwellenleiterkabel aufweist, durch die ein stromführender elektrischer Leiter hindurchgeführt werden kann. Die magnetooptische Strommesseinrichtung ermöglich eine Messung des Wertes eines aktuell durch den elektrischen Leiter fließenden Stromes. Hierzu wird in die Sensorspule polarisiertes Licht mit möglichst konstanter Wellenlänge eingespeist. Dabei wird die Polarisation des Lichtes abhängig von der Stärke des durch den elektrischen Leiter hindurch fließenden Stromes verändert. Eine Auswertung dieser Polarisationsveränderung ermöglicht einen Rückschluss auf den aktuellen Wert des Stromes im elektrischen Leiter.

Magnetooptische Strommesseinrichtungen dieser Art sind z.B. in der EP 0721 590 B1 und der EP 0 799 426 B1 beschrieben.

Bei derartigen magnetooptischen Strommesseinrichtungen können bereits geringfügige Veränderungen, z.B. bei den Umgebungsbedingungen, die Güte des in das Lichtwellenleiterkabel der Sensorspule eingespeisten polarisierten Lichts beeinflussen und damit eine Messungenauigkeit bei der Bestimmung der Stärke des Stromes im elektrischen Leiter verursachen. Für eine genaue Erfassung von Stromistwerten ist es erforderlich, dass das eingespeiste Licht eine möglichst gleichbleibende Wellenlänge aufweist.

Der Erfindung liegt die Aufgabe zugrunde, eine magnetooptische Strommesseinrichtung so weiterzubilden, dass eine möglichst hohe Messgenauigkeit auch bei veränderlichen Umgebungsbedingungen aufrechterhalten werden kann.

Die Aufgaben wird gelöst mit der im Anspruch 1 angegebenen magnetooptischen Strommesseinrichtung. Diese enthält eine Sensoreinheit mit mindestens einer Sensorspule aus Lichtwellenleiterkabel, durch die ein stromführender elektrischer Leiter hindurchführbar ist. Ferner ist ein optischer Transmitter mit mindestens einem Lichtquellenmodul zur Erzeugung von polarisiertem Licht und mit einer Einspeisevorrichtung für das polarisierte Licht in die Sensoreinheit vorhanden. Eine Ansteuerschaltung für das Lichtquellenmodul weist eine Temperaturregelung zumindest für die Temperatur des Lichtquellenmoduls auf. Schließlich ist enthalten ein optischer Empfänger, der das Licht nach Durchlauf durch die Sensoreinheit empfängt, dessen Polarisation auswertet und daraus einen die Größe eines Stromes in einem elektrischen Leiter kennzeichnenden elektrischen Messwert bildet.

Weitere vorteilhafte Ausführungsformen der Erfindung sind in den Unteransprüchen angegeben.

Der Vorteil der erfindungsgemäßen magnetooptischen Strommesseinrichtung liegt darin, dass insbesondere das Lichtquellenmodul im optischen Transmitter, welches monochromes Licht mit möglichst gleichbleibender Wellenlänge erzeugen und in die Sensoreinheit einspeisen soll, temperaturmäßig stabilisiert ist. Die Temperaturregelung in der Ansteuerschaltung bewirkt somit auch bei veränderlichen Umgebungsbedingungen eine weitgehende Konstanthaltung der Temperatur insbesondere des Lichtquellenmoduls. Dabei kann die Temperaturregelung abhängig von den aktuellen Umgebungsbedingungen erwärmend oder kühlend auf das Lichtquellenmodul einwirken. Das Lichtquellenmodul kann somit polarisiertes Licht mit einer quasi konstanten Wellenlänge unabhängig von Temperaturdriften emittiert, die durch schwankende Umgebungsbedingungen oder auch durch Veränderungen im Inneren der magnetooptischen Messeinrichtung selbst hervorgerufen werden. Hierdurch wird die Messgenauigkeit bei der Auswertung der durch den Fluss eines zu messenden elektrischen Stromes verursachten Änderung in den Polarisation des Lichtes in der Sensorspule erheblich verbessert.

Vorteilhaft weist die Temperaturregelung in der Ansteuerschaltung einen Temperaturregler, einen Temperatursensor zur Erfassung des Istwertes der Temperatur im Bereich des Lichtquellenmoduls und ein steuerbares Einstellelement zur Beeinflussung der Temperatur des Lichtquellenmoduls auf. Vorteilhaft können der Temperatursensor und das steuerbare Einstellelement für die Temperatur in das Lichtquellenmodul integriert sein. Bei einer besonders vorteilhaften Ausführungsform enthält das Lichtquellenmodul zumindest eine Halbleiterluminiszenzdiode zur Erzeugung von polarisiertem Licht mit möglichst gleichbleibender Wellenlänge, welche bevorzugt als eine Baueinheit gemeinsam mit einem Peltierelement als steuerbares Einstellelement für die Temperatur des Lichtquellenmoduls und mit einem temperaturabhängigen Widerstand als Temperatursensor für den Istwert der Temperatur des Lichtquellenmoduls ausgeführt sein kann.

Mit einer magnetooptischen Strommesseinrichtung gemäß der Erfindung und einer entsprechenden Halbleiterluminiszenzdiode zur Erzeugung von polarisiertem Licht kann z.B. Licht mit einer nahezu gleichbleibenden Wellenlänge von etwa 820nm erzeugt werden, wobei eine durch Driftabweichungen verbleibende Toleranz auf lediglich ± 0,5 nm beschränkt ist.

Insbesondere dann, wenn der Temperaturregler PID-Verhalten aufweist und das steuerbare Einstellelement z.B. ein Peltierelement ist, womit abhängig von den jeweiligen Umweltbedingungen sowohl eine Abkühlung als auch eine Aufheizung erzielbar ist, kann die Temperatur und damit die Wellenlänge des vom Lichtquellenmodul emittierten Lichtes konstant gehalten werden.

Bei einer besonders vorteilhaften Ausführung der magnetooptischen Strommesseinrichtung weist der Temperaturregler Mittel zur pulsweitenmodulierten Vorgabe eines Stellsignals für das steuerbare Einstellelement auf. Durch den Einsatz derartiger, auf der Basis von Pulsweitenmodulation beruhender Mittel können die für das steuerbare Einstellelement bestimmten Stellsignale in einer Weise generiert werden, bei der nur wenig Verlustleistung auftritt. Zumindest die Ansteuerschaltung kann somit schaltungstechnisch sehr kompakt aufgebaut werden, da keine aufwendigen Maßnahmen z.B. zur Wärmeabfuhr erforderlich sind.

Schließlich kann die Messgenauigkeit der erfindungsgemäßen magnetooptischen Strommesseinrichtung weiter dadurch verbessert werden, dass die Ansteuerschaltung für das Lichtquellenmodul Mittel zur Erzeugung eines konstanten Speisestromes für das Lichtquellenmodul aufweist, d.h. insbesondere für eine darin enthaltene Halbleiterluminiszenzdiode.

Die Erfindung wird an Hand der in den nachfolgend kurz angegebenen Figuren enthaltenen Beispielen näher erläutert. Dabei zeigt
- Figur 1:: die wesentlichen Elemente einer bevorzugten Ausführungsform der erfindungsgemäßen magnetooptischen Strommesseinrichtung in Form eines Blockschaltbildes,
- Figur 2:: eine bevorzugte Ausführungsform für einen optischen Transmitter und eine Ansteuerschaltung für das Lichtquellenmodul gemäß der Erfindung in Form eines Blockschaltbildes, und
- Figur 3:: eine bevorzugte Ausführungsform für eine Temperaturregelung in der Ansteuerschaltung, welche zur Stabilisierung der Temperatur im Bereich des Lichtquellenmoduls pulsweitenmodulierte Stellsignale für ein steuerbares Einstellelement generiert.

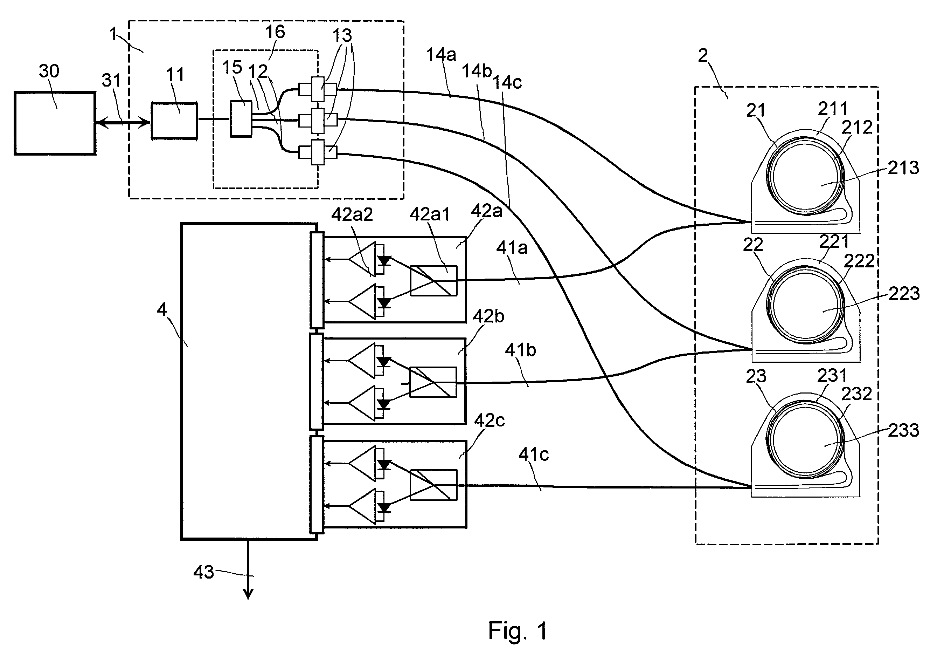

Im Beispiel der Figur 1 sind die wesentlichen Elemente einer bevorzugten, dreiphasigen Ausführungsform einer magnetooptischen Strommesseinrichtung gemäß der Erfindung in Form eines Blockschaltbildes gezeigt. Diese enthält eine entsprechend dreiphasige Sensoreinheit 2. Diese Sensoreinheit 2 weist drei separate Sensorspulen 21,22,23 aus gewickeltem Lichtwellenleiterkabel 212,222,232 auf, die in je einem Gehäuse 211,221,231 angeordnet sind und durch die jeweils ein stromführender, elektrischer Leiter 213,223,233 insbesondere eines Dreiphasensystems hindurchgeführt ist.

Gemäß der Erfindung wird Licht mit konstanter Wellenlänge von einem optischen Transmitter 1 generiert und über Lichtwellenleiterkabel 14a,14b,14c, welche als Zuleitungen dienen, den Sensorspulen 21,22,23 in der Sensoreinheit 2 zugeführt. Der Transmitter 1 enthält ein Lichtquellenmodul 11, welches polarisiertes Licht möglichst einer Wellenlänge generiert. Bei einer dreiphasigen Anordnung wird das Licht in einer Einspeisevorrichtung 16 durch einen nachgeschalteten optischen Splitter 15 von einer auf drei Phasen aufgesplittet. Dieses Licht wird in der Einspeisevorrichtung 16 über optische Zuleitungen 12 und optische Steckverbinder 13 getrennt für jede Phase in die Lichtwellenleiterkabel 14a,14b,14c eingespeist. Ferner wird das Lichtquellenmodul 11 im optischen Transmitter 1 erfindungsgemäß von einer Ansteuerschaltung 30 über Messund Stellsignalleitungen 31 angesteuert.

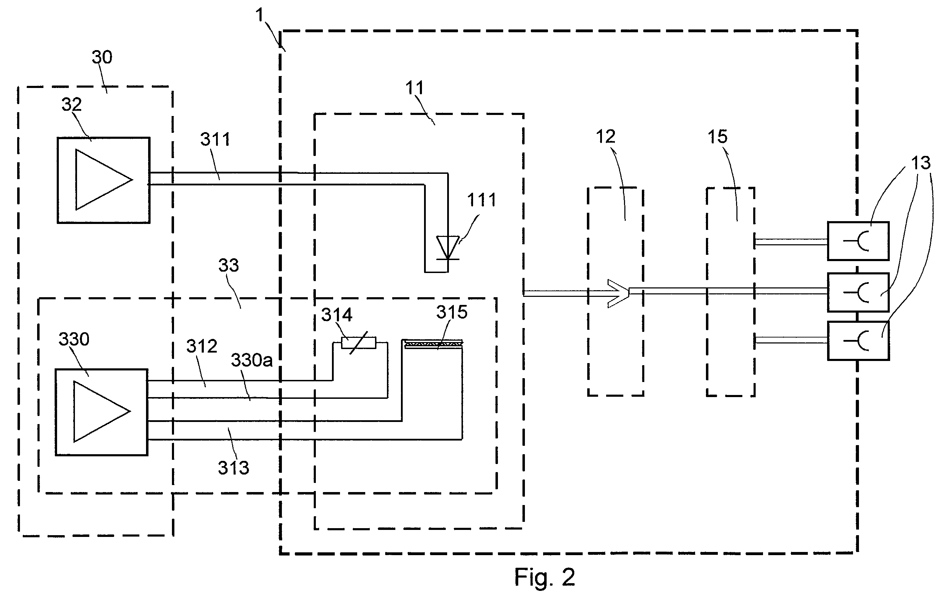

Ein vorteilhafter Aufbau eines optischen Transmitters 1 mit einer Ansteuerschaltung 30 wird am Beispiel eines in der Figur 2 gezeigten Blockschaltbildes nachfolgend noch näher erläutert werden.

Nachdem im Blockschaltbild der Figur 1 das Licht die Lichtwellenleiterleiterkabel 212,222,232 einer jeden Sensorspule 21,22,23 durchlaufen hat, wird es über weitere Lichtwellenleiterkabel 41a,41b,41c einem optischen Empfänger 4 zugeleitet. Dieser weist pro Phase einen Empfangsteil 42a,42b,42c auf, in dem das Licht in entsprechende elektrische Signale umgewandelt wird. Hierzu verfügt ein jedes Empfangsteil über ein Polarisationsfilter, in dem das Licht aufgeteilt und einem Paar von optoelektrischen Kopplern, z.B. fotoempfindlichen Elementen bzw. optisch steuerbaren Dioden, zugeführt wird. Diesen sind jeweils Verstärker nachgeschaltet, welche hieraus ein entsprechendes elektrisches Messsignal ableiten. So weist beispielsweise das Empfangsteil 42a ein Polarisationsfilter 42a1 und einen optoelektrischen Koppler 42a2 auf. Am Ausgang des optischen Empfängers 4 stehen schließlich elektrische Messwerte 43 für die Ströme durch die stromführenden elektrischen Leiter 213,223,233 zu Verfügung.

Im Beispiel der Figur 2 ist eine bevorzugte Ausführungsform für einen optischen Transmitter 1 gemäß der Erfindung in Form eines Blockschaltbildes gezeigt. Dieser enthält ein Lichtquellenmodul 11, welches von einer Ansteuerschaltung 30 gespeist wird. Die Ansteuerschaltung 30 beinhaltet eine Temperaturregelung 33 zur Stabilisierung der Temperatur im Bereich des Lichtquellenmoduls 11 und vorteilhaft zusätzliche Mittel 32 zur Erzeugung eines konstanten Speisestromes für das Lichtquellenmodul 11. Dieses weist zumindest eine insbesondere integrierte Leuchtdiode 111 auf, z.B. eine Halbleiterluminiszenzdiode.

Die zusätzlichen Mittel zur Erzeugung eines konstanten Speisestromes weisen vorteilhaft einen Konstantstromregler 32 auf. Über eine Zuführung 311 wird der hiervon erzeugte konstante Speisestrom einer beispielhaften Halbleiterluminiszenzdiode 111 im Lichtquellenmodul 11 zugeführt.

Die Temperaturregelung 33 für das Lichtquellenmodul 11 weist vorteilhaft einen Temperaturregler 330, einen Temperatursensor 314 und ein steuerbares Einstellelement 315 für die Temperatur des Lichtquellenmoduls 11 auf. Vorzugsweise sind die Elemente Temperatursensor 314 und steuerbares Einstellelement 315 in das Lichtquellenmodul 11 integriert. Sie können aber in einer anderen, nicht dargestellten Ausführungsform auch von außen z.B. auf ein Gehäuse des Lichtquellenmoduls 11 aufgesetzt sein. Vorteilhaft ist das steuerbares Einstellelement 315 für die Temperatur des Lichtquellenmoduls 11 ein Peltierelement, welches abhängig von der Richtung des durchfließenden Stromes eine kühlende bzw. erwärmende Funktion hat. Im Beispiel der Figur 2 ist der Temperatursensor 314 mit dem Temperaturregler 330 über Messsignalleitungen 312 verbunden. Hierüber wird dem Temperaturregler 330 ein Temperaturistwert 330a zugeführt. Ferner ist das steuerbare Einstellelement 315 für die Temperatur des Lichtquellenmoduls 11 über Stellsignalleitungen 313 mit dem Temperaturregler 330 verbunden. Hierüber gibt der Temperaturregler 330 dem steuerbaren Einstellelement 315 Stellsignale vor.

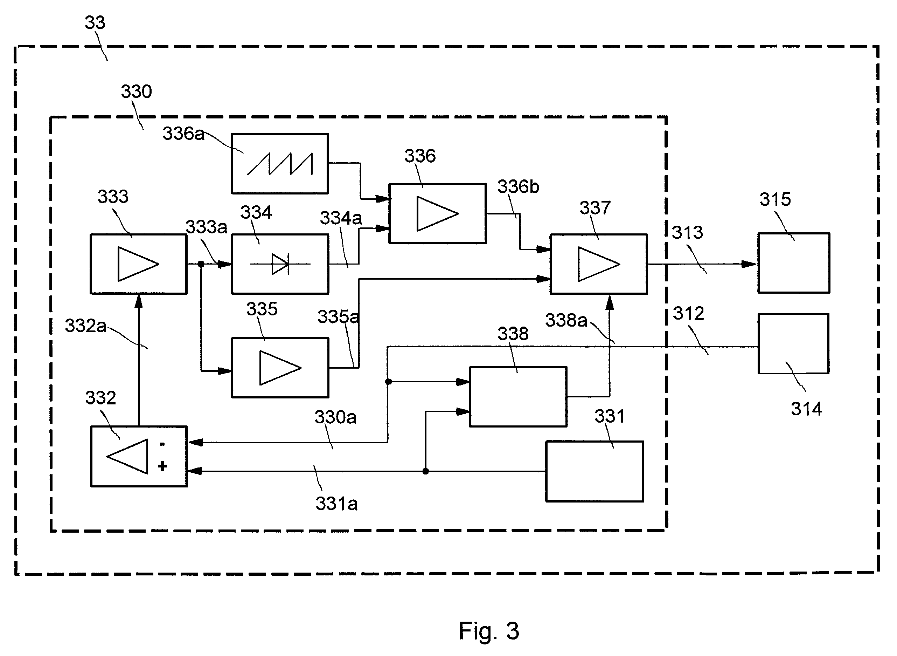

In Figur 3 ist eine bevorzugte Ausführungsform für eine Temperaturregelung 33 gezeigt, welche eine Stabilisierung der Temperatur im Bereich des Lichtquellenmoduls 11 der erfindungsgemäßen magnetooptischen Strommesseinrichtung bewirkt. Dabei ist der Temperaturregler 330 der Temperaturregelung 33 besonders vorteilhaft unter Verwendung einer sogenannten Pulsweitenmodulation aufgebaut. Ein Temperaturistwert 330a, der vom Temperatursensor 314 über die Messsignalleitung 312 bereitgestellt wird, und ein Temperatursollwert 331a, der von einer Einrichtung zur Sollwertvorgabe 331 z.B. einem Potentiometer bereitgestellt wird, werden einem Vergleicher 332 zugeführt. Dieser leitet aus dem Soll- und Istwert eine Regelabweichung 332a für die Temperatur im Bereich des Lichtquellenmoduls 11 ab. Die Regelabweichung 332a wird einem Regler 333 zugeführt, bevorzugt einem PID Regler, der hieraus ein analoges Stellsignal 333a bildet.

Das analoge Stellsignal 333a wird einerseits einem Gleichrichter 334 zugeführt, der hieraus den Betrag des Stellsignales 334a ableitet, und einem Vorzeichenverstärker 335, der hieraus das Vorzeichen 335a des analogen Stellsignals 333a ableitet. Der Betrag des Stellsignales 334a wird einem Leistungsstellglied 336 zugeführt. Dieses ist bevorzugt als ein pulsweitenmodulierter Komparator ausgebildet, dem ein Grundsignal von einem Sägezahngenerator 336a zugeführt wird. Durch Überlagerung des dreieckförmigen Signals aus dem Sägezahngenerator 336a und dem Betrag des Stellsignales 334a werden pulsweitenmodulierte, rechteckförmige Stellsignale 336b generiert und einem Endverstärker 337 zugeführt. Dieser bildet die Stellsignale 313 für das steuerbare Einstellelement 315 bevorzugt in Form von Pulsketten. Das Vorzeichensignal 335a wird ebenfalls dem Endverstärker 337 zugeführt. Dieser wird hierdurch abhängig von den um das Lichtquellenmodul 11 vorliegenden Umgebungsbedingungen so umgeschaltet, dass auf Grund des jeweiligen Vorzeichens der Stellsignale 313 eine einstellbare Heizwirkung bzw. Kühlwirkung des steuerbaren Einstellelements 315 hervorrufen. Im Endverstärker 337 werden die pulsweitenmodulierten, rechteckförmigen Stellsignale ferner vorzeichenrichtig in ein entsprechendes, analoges Stellsignal für ein als steuerbares Einstellelement 315 dienendes Peltierelement konvertiert.

Schließlich weist der Temperaturregler 330 von Figur 3 noch eine Schutzschaltung 338 auf. Diese bewirkt über ein Abschaltsignal 338a eine Abschaltung des Endverstärkers 337, wenn die Differenz zwischen dem Temperaturistwert 330a und dem Temperatursollwert 331a einen vorgegebenen Grenzwert überschreitet.

## Patentansprüche

1. Magnetooptische Strommesseinrichtung, enthaltend
a) eine Sensoreinheit (2) mit mindestens einer Sensorspule (21,22,23) aus Lichtwellenleiterkabel (212,222,232), durch die ein stromführender elektrischer Leiter (213,223,233) hindurchführbar ist,
b) einen optischen Transmitter (1) mit mindestens einem Lichtquellenmodul (11) zur Erzeugung von polarisiertem Licht und mit einer Einspeisevorrichtung (16) für das polarisierte Licht in die Sensoreinheit (2),
c) eine Ansteuerschaltung (30) für das Lichtquellenmodul (11), die eine Temperaturregelung (33) zumindest für die Temperatur des Lichtquellenmoduls (11) aufweist, und
d) einen optischen Empfänger (4), der das Licht nach Durchlauf durch die Sensoreinheit (2) empfängt, dessen Polarisation auswertet und daraus einen die Größe eines Stromes in einem elektrischen Leiter (213,223,233) kennzeichnenden elektrischen Messwert (43) bildet.

2. Magnetooptische Strommesseinrichtung nach Anspruch 1, **dadurch gekennzeichnet, dass** die Temperaturregelung (33) einen Temperaturregler (330), einen Temperatursensor (314) für den Istwert der Temperatur des Lichtquellenmoduls (11) und ein steuerbares Einstellelement (315) für die Temperatur im Bereich des Lichtquellenmoduls (11) aufweist.

3. Magnetooptische Strommesseinrichtung nach Anspruch 2, **dadurch gekennzeichnet, dass** der Temperaturregler (330) Mittel (336,336a) zur pulsweitenmodulierten Vorgabe eines Stellsignals (313) für das steuerbare Einstellelement (315) aufweist.

4. Magnetooptische Strommesseinrichtung nach einem der Ansprüche 2 oder 3, **gekennzeichnet durch** ein Peltier-element als steuerbares Einstellelement (315) für die Temperatur des Lichtquellenmoduls (11).

5. Magnetooptische Strommesseinrichtung nach einem der Ansprüche 2 bis 4, **gekennzeichnet durch** einen temperaturabhängigen Widerstand als Temperatursensor (314) für den Istwert der Temperatur des Lichtquellenmoduls (11).

6. Magnetooptische Strommesseinrichtung nach einem der Ansprüche 2 bis 5, **dadurch gekennzeichnet, dass** der Temperatursensor (314) und das steuerbare Einstellelement (315) für die Temperatur in das Lichtquellenmodul (11) integriert sind.

7. Magnetooptische Strommesseinrichtung nach einem vorangegangenen Ansprüche, **dadurch gekennzeichnet, dass** das Lichtquellenmodul (11) zumindest eine Halbleiterluminiszenzdiode enthält.

8. Magnetooptische Strommesseinrichtung nach einem der vorangegangenen Ansprüche, **dadurch gekennzeichnet, dass** die Ansteuerschaltung (30) für das Lichtquellenmodul (11) Mittel (32) zur Erzeugung eines konstanten Speisestromes (311) für das Lichtquellenmodul (11) aufweist.
